# EUROPEAN PATENT APPLICATION

(11) **EP 4 697 883 A1**
(43) Date of publication of application: **18.02.2026**
(21) Application number: 25719604.8
(22) Date of filing: 07.04.2025
(51) Int. Cl.: H05K 7/20, H05K 5/00

(54) **ELECTRONIC DEVICE INCLUDING HEAT DISSIPATION SEAT AND CUSHION**

(30) Priority: 04.07.2024 KR 20240088542; 09.07.2024 KR 20240090741
(71) Applicant: Samsung Electronics Co., Ltd., Suwon-si, Gyeonggi-do 16677 (KR)
(72) Inventor: WOO, Jeong, Suwon-si, Gyeonggi-do 16677 (KR)
(74) Representative: Appleyard Lees IP LLP
(86) International application number: PCT/KR2025/004704
(87) International publication number: WO 2026/010081

(57) **Abstract**

An electronic device includes a housing, a display, a first encapsulation film disposed on the housing, a heat dissipation sheet, positioned under the display, disposed on a first portion of the first encapsulation film, a cushion, positioned under the display, disposed on a second portion of the first encapsulation film and spaced apart from the heat dissipation sheet, a second encapsulation film covering the heat dissipation sheet and partially covering the cushion. In addition to this, various embodiments are possible.

## Description

### [Technical Field]

The present disclosure relates to an electronic device including a heat dissipation sheet and a cushion.

### [Background Art]

An electronic device may include housing parts that are rotatably coupled and a flexible display. According to a rotation of the housing parts, a portion of the flexible display may be bent. The electronic device may include a cushion for protecting the flexible display. The cushion may be disposed under the flexible display.

The electronic device may include electronic components for providing various functions of the electronic device. When the electronic components operate, heat may be caused from the electronic components. In order to dissipate heat caused by the electronic components, the electronic device may include a heat dissipation sheet.

The above-described information may be provided as a related art for the purpose of helping understanding of the present disclosure. No argument or decision is made as to whether any of the above description may be applied as a prior art related to the present disclosure.

### [Disclosure]

### [Technical Solution]

An electronic device is provided. The electronic device may comprise a housing. The electronic device may comprise a display. The electronic device may comprise a first encapsulation film disposed on the housing. The electronic device may comprise a heat dissipation sheet, positioned under the display, disposed on a first portion of the first encapsulation film. The electronic device may comprise a cushion, positioned under the display, disposed on a second portion of the first encapsulation film and spaced apart from the heat dissipation sheet. The electronic device may comprise a second encapsulation film covering the heat dissipation sheet and partially covering the cushion.

An electronic device is provided. The electronic device may comprise a foldable housing including a first housing part and a second housing part rotatably coupled to the first housing part. The electronic device may comprise a flexible display disposed over the foldable housing. The electronic device may comprise an encapsulation structure disposed between the foldable housing and the flexible display. The encapsulation structure may include a first encapsulation film disposed on the foldable housing, a heat dissipation sheet, positioned under the flexible display, disposed on a first portion of the first encapsulation film, a cushion, positioned under the flexible display, disposed on a second portion of the first encapsulation film and spaced apart from the heat dissipation sheet, and a second encapsulation film at least partially covering the heat dissipation sheet and the cushion.

### [Description of the Drawings]

FIG. 1 is a block diagram of an electronic device in a network environment according to an embodiment.
FIG. 2A illustrates an example of an unfolded state of an electronic device according to an embodiment.
FIG. 2B illustrates an example of a folded state of an electronic device according to an embodiment.
FIG. 2C is an exploded view of an electronic device according to an embodiment.
FIGS. 3A and 3B illustrate an interior of an electronic device according to an embodiment.
FIG. 4 is a cross-sectional view of the electronic device of FIG. 3A, cut along line A-A'.
FIG. 5A illustrates an encapsulation structure according to an embodiment.
FIG. 5B is an exploded perspective view of an encapsulation structure according to an embodiment.
FIG. 6A is a plan view of an encapsulation structure according to an embodiment.
FIG. 6B is a cross-sectional view of the encapsulation structure of FIG. 6A, cut along line B-B'.
FIG. 7A is a plan view of an encapsulation structure according to an embodiment.
FIG. 7B is a cross-sectional view of the encapsulation structure of FIG. 7A, cut along line C-C'.
FIG. 8 illustrates an example of an encapsulation structure in which a cushion is disposed on a second encapsulation film.
FIG. 9 illustrates an encapsulation structure according to an embodiment including a shield sheet.

### [Mode for Invention]

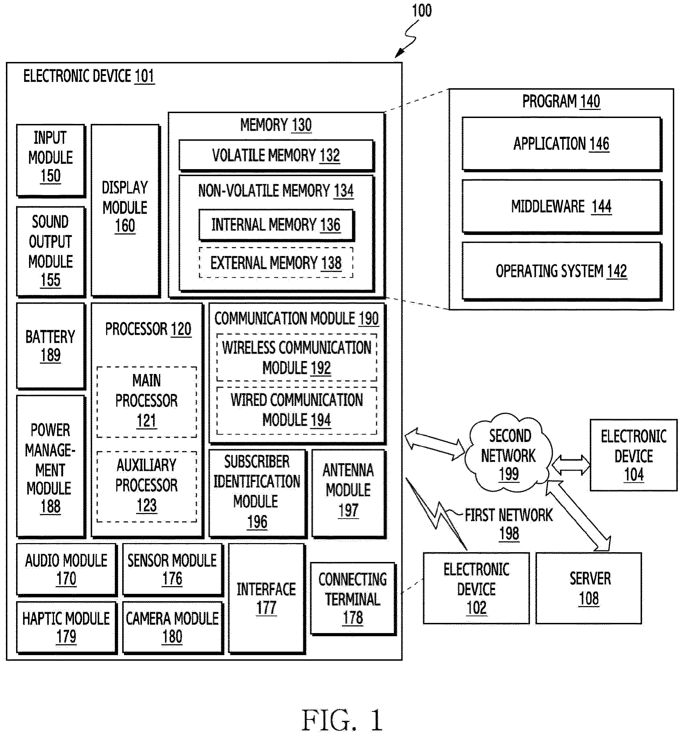

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

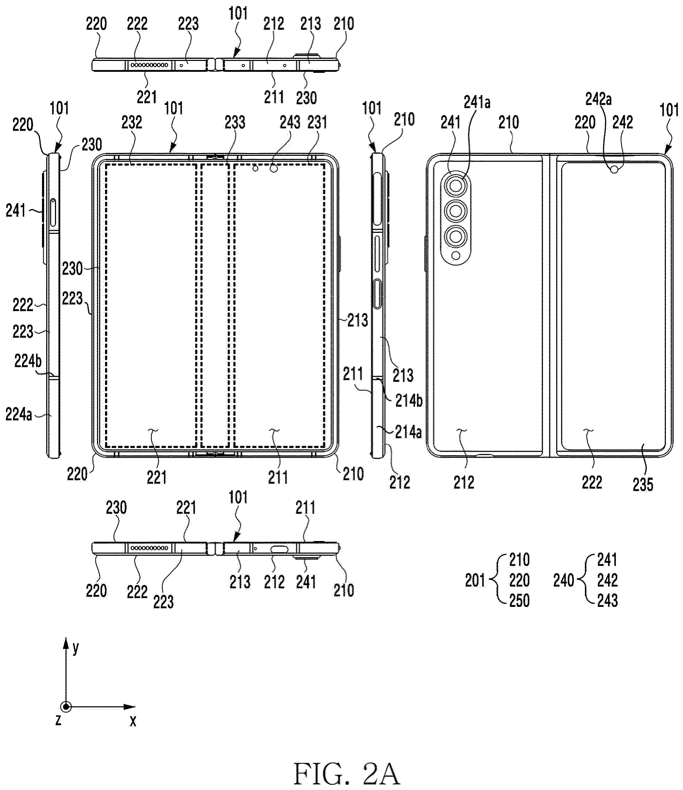

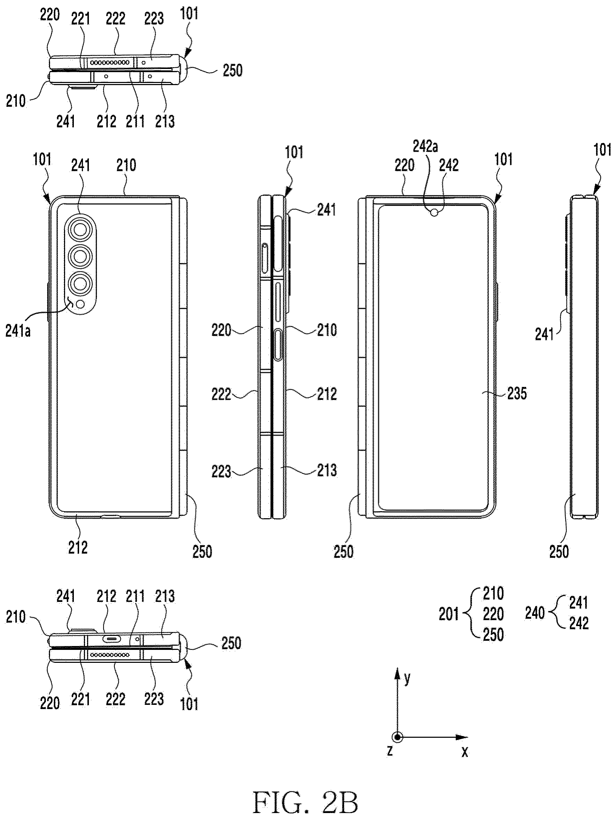

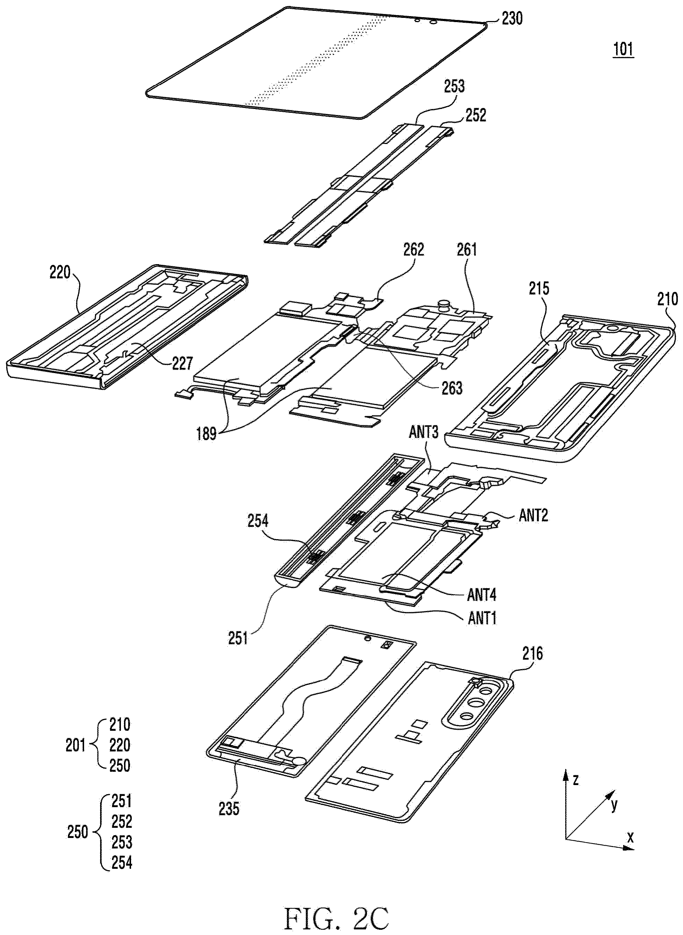

FIG. 2A illustrates an example of an unfolded state of an electronic device according to an embodiment. FIG. 2B illustrates an example of a folded state of an electronic device according to an embodiment. FIG. 2C is an exploded view of an electronic device according to an embodiment.

Referring to FIGS. 2A, 2B, and 2C, an electronic device 101 according to an embodiment may include a foldable housing 201, a display 230 (e.g., the display module 160 of FIG. 1), or one or more cameras 240.

According to an embodiment, the foldable housing 201 may define an exterior surface of the electronic device 101. For example, the foldable housing 201, which is a physical exterior surface of the electronic device 101 exposed to the outside, may accommodate components disposed inside the electronic device 101. At least a portion of the components for implementing a function of the electronic device 101 may be disposed in the foldable housing 201. According to an embodiment, the foldable housing 201 may include a first housing part 210, a second housing part 220, and a hinge assembly 250.

According to an embodiment, the first housing part 210 may include a first surface 211, a second surface 212 opposite to the first surface 211, and a first lateral surface 213 at least partially surrounding a periphery of the first surface 211 and a periphery of the second surface 212. For example, the first surface 211 may be referred to as a front exterior surface of the first housing part 210, and the second surface 212 may be referred to as a rear exterior surface of the first housing part 210. The first lateral surface 213 may be connected to the periphery of the first surface 211 and the periphery of the second surface 212. The first surface 211, the second surface 212, and the first lateral surface 213 may form an inner space of the first housing part 210. For example, at least one component may be disposed in a space surrounded by the first surface 211, the second surface 212, and the first lateral surface 213.

According to an embodiment, the second housing part 220 may include a third surface 221, a fourth surface 222 opposite to the third surface 221, and a second lateral surface 223 at least partially surrounding a periphery of the third surface 221 and a periphery of the fourth surface 222. For example, the third surface 221 may be referred to a front exterior surface of the second housing part 220, and the fourth surface 222 may be referred to a rear exterior surface of the second housing part 220. The second lateral surface 223 may be connected to the periphery of the third surface 221 and the periphery of the fourth surface 222. The third surface 221, the fourth surface 222, and the second lateral surface 223 may form an inner space of the second housing part 220. For example, at least one component may be disposed in a space surrounded by the third surface 221, the fourth surface 222, and the second lateral surface 223.

According to an embodiment, the display 230 may be configured to display visual information. For example, the display 230 may include a display area including a plurality of pixels. For example, an active area may be referred to as an active area displaying visual information.

According to an embodiment, the display 230 may include a first planar portion 231, a second planar portion 232, and a bending portion 233 disposed between the first planar portion 231 and the second planar portion 232. The electronic device 101 may further include a cover display 235 distinguished from the display 230. The cover display 235 may be referred to as a sub-display.

According to an embodiment, the first planar portion 231 may be supported by the first housing part 210. The second planar portion 232 may be supported by the second housing part 220. The first planar portion 231 and the second planar portion 232 may be substantially planar independently of a state of the electronic device 101. The bending portion 233 may be configured to be bent based on a rotation of the first housing part 210 and the second housing part 220. For example, in the unfolded state in which the first housing part 210 and the second housing part 220 are unfolded, the bending portion 233 may be substantially planar. In the folded state or an intermediate state in which the first housing part 210 and the second housing part 220 are folded, the bending portion 233 may be at least partially bent. The display 230 may be a flexible display including the bending portion 233 that bends.

According to an embodiment, the one or more cameras 240 may be configured to obtain an image based on receiving light from a subject outside the electronic device 101. For example, the one or more cameras 240 may include first cameras 241, a second camera 242, and/or a third camera 243. For example, the first cameras 241 may be disposed in the first housing part 210. For example, when the electronic device 101 is viewed from above, the first housing part 210 may include at least one opening 241a overlapping the first cameras 241. The first cameras 241 may obtain an image based on receiving light from the outside of the electronic device 101 through the at least one opening 241a.

According to an embodiment, the second camera 242 may be disposed in the second housing part 220. The second housing part 220 may include at least one opening 242a overlapping the second camera 242 when the electronic device 101 is viewed from above. The second camera 242 may obtain an image based on receiving light from the outside of the electronic device 101 through the at least one opening 242a.

According to an embodiment, the third camera 243 may be disposed in the first housing part 210. For example, the first planar portion 231 of the display 230 may include at least one opening overlapping the third camera 243 when the display 230 is viewed from above. The third camera 243 may obtain an image based on receiving light from the outside of the display 230 through the at least one opening.

According to an embodiment, the second camera 242 and the third camera 243 may be disposed under (e.g., a -z direction) the display 230 or the cover display 235. For example, the second camera 242 and/or the third camera 243 may include an under display camera (UDC) and/or a punch hole camera.

According to an embodiment, the first housing part 210 and the second housing part 220 may be rotatably coupled. For example, the second housing part 220 may be rotatably coupled to the first housing part 210 through the hinge assembly 250.

According to an embodiment, the hinge assembly 250 may rotatably connect the first housing part 210 and the second housing part 220. The hinge assembly 250 may be disposed between the first housing part 210 and the second housing part 220 of the electronic device 101 so that the electronic device 101 may be folded. The hinge assembly 250 may allow the electronic device 101 to change from the unfolded state to the folded state. The hinge assembly 250 may allow the electronic device 101 to change from the folded state to the unfolded state. For example, the hinge assembly 250 may maintain the electronic device 101 in the intermediate state between the unfolded state and the folded state.

According to an embodiment, the unfolded state may be referred to as a state in which a first direction toward which the first planar portion 231 faces and a second direction toward which the second planar portion 232 faces are substantially the same. The folded state may be referred to as a state in which the first direction is substantially opposite to the second direction. When the electronic device 101 is in the folded state, the first housing part 210 and the second housing part 220 may be stacked or overlapped.

According to an embodiment, when the electronic device 101 is in the folded state and the intermediate state, the first direction and the second direction may be different from each other. For example, when the electronic device 101 is in the folded state, the first direction and the second direction may be opposite to each other. For example, when the electronic device 101 is in the intermediate state, the first direction may form an angle (e.g., an angle greater than 0 degrees and less than 180 degrees) with respect to the second direction.

For example, the electronic device 101 may include at least one conductive portion 214a and 224a and at least one non-conductive portion 214b and 224b included in the first lateral surface 213 and/or the third lateral surface 223. For example, the at least one conductive portion 214a and 224a may be separated from another conductive portion in the first lateral surface 213 and/or the third lateral surface 223 by contacting the at least one non-conductive portion 214b and 224b. In an embodiment, the at least one conductive portion 214a and 224a may operate as an antenna radiator to be used for communication with an external electronic device.

Referring to FIG. 2C, the hinge assembly 250 may include a hinge cover 251, a first hinge plate 252, a second hinge plate 253, and a plurality of hinge modules 254. The hinge cover 251 may at least partially surround components of the hinge assembly 250 and form an outer surface of the hinge assembly 250. When the electronic device 101 is in the folded state, the hinge cover 251 may be at least partially exposed to the outside of the electronic device 101 through a space between the first housing part 210 and the second housing part 220. When the electronic device 101 is in the unfolded state, the hinge cover 251 may not be exposed to the outside of the electronic device 101, by being covered by the first housing part 210 and the second housing part 220.

According to an embodiment, the first hinge plate 252 and the second hinge plate 253 are operatively coupled to the first housing part 210 and the second housing part 220, respectively, so that the first housing part 210 and the second housing part 220 may be rotatably connected. For example, the first hinge plate 252 may be operatively coupled to a first support 215 of the first housing part 210, and the second hinge plate 253 may be operatively coupled to a second support 227 of the second housing part 220. As the first hinge plate 252 and the second hinge plate 253 are operatively coupled to the first support 215 and the second support 227, respectively, the first housing part 210 and the second housing part 220 may be rotatable according to a rotation of the first hinge plate 252 and the second hinge plate 253.

According to an embodiment, the plurality of hinge modules 254 may rotate the first hinge plate 252 and the second hinge plate 253. For example, the plurality of hinge modules 254 may include gears that are rotatable by being engaged with each other. The first hinge plate 252 and the second hinge plate 253 may be rotated based on a rotation operation of the gears of the plurality of hinge modules 254.

According to an embodiment, the first housing part 210 may include the first support 215 and a rear cover 216. The first support 215 may be disposed inside the first housing part 210 and may support at least one component disposed in the first housing part 210. The rear cover 216 may at least partially form the second surface 222 of the first housing part 210. For example, the second housing part 220 may include the second support 227. The second support 227 may be disposed inside the second housing part 220 and may support at least one component disposed in the second housing part 220. For example, the cover display 235 may be disposed under (e.g., the -z direction) the second support 227.

The electronic device 101 according to an embodiment may include a plurality of electronic components for implementing various functions in addition to the one or more cameras 240 described above. For example, the electronic device 101 may include a first printed circuit board 261, a second printed circuit board 262, a flexible printed circuit board 263, and/or a battery 189. The above-described electronic components are merely exemplary and are not limited thereto.

For example, the first printed circuit board 261 and the second printed circuit board 262 may each provide an electrical connection of components in the electronic device 101. For example, the first printed circuit board 261 may be disposed in the first housing part 210, and the second printed circuit board 262 may be disposed in the second housing part 220. The first printed circuit board 261 may provide an electrical connection between electronic components disposed in the first housing part 210. The second printed circuit board 262 may provide an electrical connection between electronic components disposed in the second housing part 220. The flexible printed circuit board 263 may electrically connect the first printed circuit board 261 and the second printed circuit board 262. For example, the flexible printed circuit board 263 may extend from the first printed circuit board 261 to the second printed circuit board 262 across the hinge assembly 250. For example, the flexible printed circuit board 263 may at least partially overlap the hinge assembly 250.

According to an embodiment, the battery 189 is a device for supplying power to at least one component of the electronic device 101, and may include, for example, a non-rechargeable primary battery and/or a rechargeable secondary battery.

According to an embodiment, the electronic device 101 may include a plurality of antennas ANT1, ANT2, ANT3, or ANT4 to be used for communication with an external electronic device. For example, the electronic device 101 may include the main antenna ANT1, the sub-antenna ANT2, the ultra-wide band (UWB) antenna ANT3, and/or the antenna ANT4 for short-range wireless communication. However, it is not limited thereto.

Hereinafter, one or more components described below with reference to the drawings may be implemented together with the components of the electronic device 101 described with reference to FIGS. 2A, 2B, and 2C. The same reference numeral is assigned to the same component as the above-described component, and an overlapping description may be omitted.

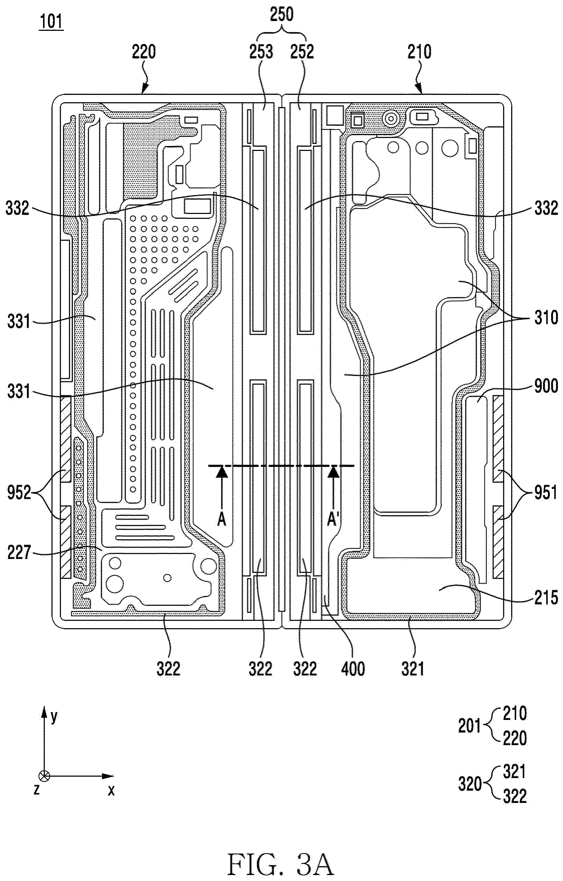

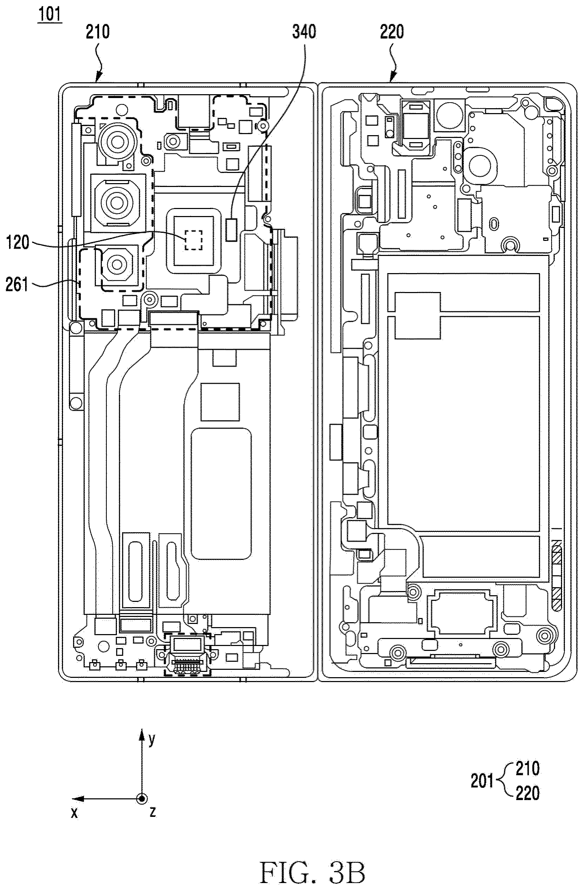

FIGS. 3A and 3B illustrate an interior of an electronic device according to an embodiment.

FIG. 3A is a front view of an electronic device 101 with a display (e.g., the display 230 of FIG. 2A) removed.

The electronic device (e.g., the electronic device 101 of FIGS. 1 and 2A) according to an embodiment may include a housing that defines an exterior surface of the electronic device 101. The housing may include a foldable housing 201 configured to be folded or unfolded. For example, the foldable housing 201 may include a first housing part 210 and a second housing part 220. The first housing part 210 and the second housing part 220 may be rotatably coupled to each other through a hinge assembly 250. For example, the hinge assembly 250 may include a first hinge plate 252 coupled to the first housing part 210 and a second hinge plate 253 coupled to the second housing part 220. The second hinge plate 253 may be rotatable with respect to the first hinge plate 252. When an external force causing a rotation is applied to the first housing part 210 and/or the second housing part 220, the first hinge plate 252 and/or the second hinge plate 253 may be rotated. A state of the electronic device 101 may be changed by rotating the first housing part 210 and/or the second housing part 220 by the rotation of the first hinge plate 252 and/or the second hinge plate 253.

According to an embodiment, the first housing part 210 may include a first support 215, and the second housing part 220 may include a second support 227. The first support 215 may support electronic components disposed in the first housing part 210. The second support 227 may support electronic components disposed in the second housing part 220.

According to an embodiment, the electronic device 101 may include the display 230. As described above, the display 230 may be a flexible display. The display 230 may include a first planar portion (e.g., the first planar portion 231 of FIG. 2A), a second planar portion (e.g., the second planar portion 232 of FIG. 2A), and a bending portion (e.g., the bending portion 233 of FIG. 2A). The first planar portion 231 may be supported by the first support 215 under (e.g., a -z direction) the first planar portion 231. The second planar portion 232 may be supported by the second support 227 under the second planar portion 232. The bending portion 233 may be configured to be bent based on the rotation of the first housing part 210 and the second housing part 220.

To allow the bending portion 233 to be bent, a glass window disposed on a front side of the display 230 may be omitted, or an ultra-thin glass (UTG) having a very thin thickness may be disposed on the front side of the display 230. Since the glass window is omitted or the UTG is disposed on the front side of the display 230, the display 230 may be easily damaged by an impact. For example, since the first support 215 and the second support 227 disposed under the display 230 are rigid, damage to the display 230 may be caused by contact between the display 230 and the supports 215 and 227.

The electronic device 101 according to an embodiment may include components for absorbing an impact applied to the display 230 under (e.g., the -z direction) the display 230.

The electronic device 101 according to an embodiment may include a waterproof tape 320. For example, the waterproof tape 320 may include a first waterproof tape 321 and a second waterproof tape 322. The first waterproof tape 321 disposed on the first support 215 and the second waterproof tape 322 disposed on the second support 227 may be formed from a material having elasticity. The first waterproof tape 321 and the second waterproof tape 322 may be disposed between the foldable housing 201 and the display 230. The first waterproof tape 321 may absorb an impact applied to the first planar portion 231 of the display 230. The second waterproof tape 322 may absorb an impact applied to the second planar portion 232 of the display 230. For example, a polymer member 331 for absorbing an impact may be disposed on the first support 215. The polymer member 331 may be formed from polyethylene. A polymer member 332 for absorbing an impact may be disposed on the first hinge plate 252 and the second hinge plate 253. The polymer member 332 may be formed from thermoplastic polyurethane (TPU).

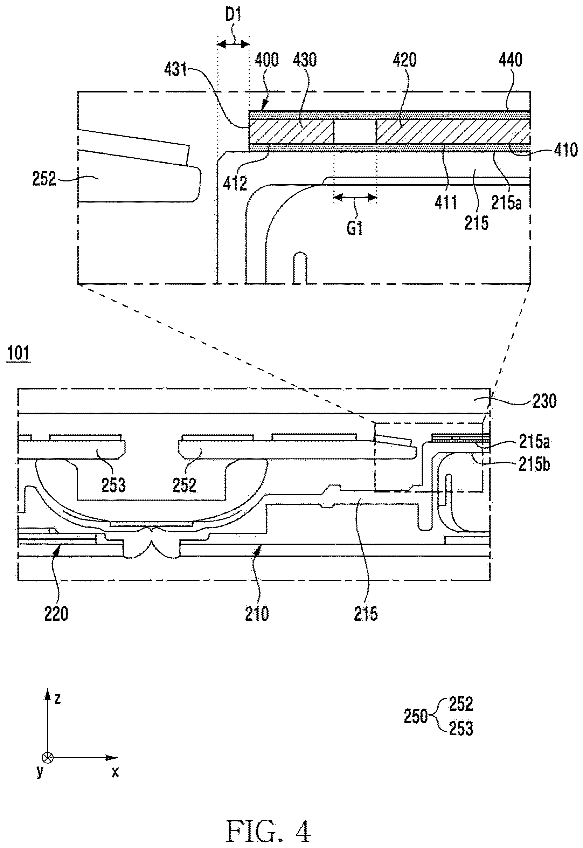

The electronic device 101 according to an embodiment may include a heat dissipation member 310 configured to dissipate heat caused by electronic components. For example, the heat dissipation member 310 may be a heat dissipation sheet (e.g., a heat dissipation sheet 420 of FIG. 4) formed from graphite having high heat conductivity. The heat dissipation member 310 may diffuse heat inside the electronic device 101 and reduce a temperature rise of the electronic device 101. A main function of the heat dissipation member 310 is heat dissipation of the electronic device 101, but since the heat dissipation member 310 is not as rigid as the first support 215 and the second support 227, impact absorption by the heat dissipation member 310 may also be possible.

FIG. 3B is a rear view of the electronic device 101 with a cover display (e.g., the cover display 235 of FIG. 2C) and a rear cover (e.g., the rear cover 216 of FIG. 2C) removed.

Referring to FIG. 3B, the electronic device 101 according to an embodiment may include a printed circuit board 261. The printed circuit board 261 may be disposed on the first support 215. The printed circuit board 261 may include a plurality of conductive layers and a plurality of non-conductive layers stacked alternately with the plurality of conductive layers. The printed circuit board 261 may provide an electrical connection between various electronic components disposed on the printed circuit board 261 or outside the printed circuit board 261 by using wires and conductive vias formed on the conductive layer.

According to an embodiment, heat caused by the electronic components disposed on the printed circuit board 261 may be diffused by a heat dissipation member (e.g., the heat dissipation member 310 of FIG. 3A). The heat caused when the electronic components disposed on the printed circuit board 261 operate may be dissipated to the outside of the electronic device 101, by conducting to the heat dissipation member 310 through the printed circuit board 261 and the first support 215, and diffusing it through the heat dissipation member 310. The heat dissipation member 310 may reduce damage to electronic components and may reduce performance degradation due to overheating, by reducing a temperature of the electronic device 101. For example, electronic components that cause heat may include a main processor 120 (e.g., an application processor (AP)) and/or power management circuitry 340, but are not limited thereto. For example, a heat dissipation sheet (e.g., the heat dissipation sheet 420 of FIG. 4) may be configured to dissipate heat by dissipating the heat caused by the main processor 120 and/or the power management circuitry 340.

Referring back to FIG. 3A, the heat dissipation member 310 may be formed from a material having high heat conductivity so as to conduct and dissipate heat. As described above, the heat dissipation member 310 may include a sheet formed from graphite. Since the graphite has flexibility, high durability, and high heat conductivity, the graphite may be suitable as a material for forming the heat dissipation member 310. Since the graphite has a single crystal, the graphite has low bursting strength and low yield strength. As the graphite has low bursting strength and low yield strength, the graphite may be easily broken. In order to prevent and/or reduce dust of the graphite from diffusing inside the electronic device 101, a graphite sheet may be disposed inside the electronic device 101 in a form of an encapsulation structure (e.g., an encapsulation structure 400 of FIG. 4) surrounded by an encapsulation film. For example, the encapsulation structure 400 may include an upper film (e.g., a second encapsulation film 440 of FIG. 4) and a lower film (e.g., a first encapsulation film 410 of FIG. 4) surrounding the graphite sheet. The graphite sheet may be disposed between the upper film and the lower film, and a periphery of the upper film and a periphery of the lower film may be attached to each other.

The heat dissipation member 310 including the graphite sheet is less rigid than the first support 215 and the second support 227, but has a lower elastic force than a component (e.g., the polymer members 331 and 332 of FIG. 3A) for absorbing an impact, and thus may not sufficiently absorb an impact applied to the display 230. Since a boundary portion of the encapsulation structure 400 is formed in a form in which the upper film and the lower film are attached to each other, the impact applied to the display (e.g., the display 230 of FIG. 2A) from the outside may not be substantially absorbed. The impact may deteriorate quality of visual information displayed on the display 230 by causing damage to the display 230.

The electronic device 101 according to an embodiment may dissipate heat caused by the electronic components (e.g., the main processor (e.g., the processor 120 of FIG. 1)) and/or the power management circuitry (e.g., the power management circuitry 340 of FIG. 3B), and may include the encapsulation structure 400 for absorbing the impact applied to the display 230. Hereinafter, the encapsulation structure 400 will be described.

FIG. 4 is a cross-sectional view of the electronic device of FIG. 3A, cut along line A-A'.

Referring to FIG. 4, an electronic device 101 according to an embodiment may include an encapsulation structure 400. The encapsulation structure 400 may include a first encapsulation film 410, a heat dissipation sheet 420, a cushion 430, and a second encapsulation film 440.

According to an embodiment, the first encapsulation film 410 may be disposed on a structure of a foldable housing 201. For example, the first encapsulation film 410 may be disposed on a first support 215. The first encapsulation film 410 may be referred to as a lower film.

According to an embodiment, the heat dissipation sheet 420 may be disposed on a first portion 411 of the first encapsulation film 410. The heat dissipation sheet 420 being disposed on the first portion 411 of the first encapsulation film 410 may be referred to as the heat dissipation sheet 420 not being disposed on an entire area of the first encapsulation film 410 and disposed on a partial area (e.g., the first portion 411) of the first encapsulation film 410. The heat dissipation sheet 420 may be positioned under (e.g., a -z direction) a display 230. The heat dissipation sheet 420 may be formed from a material having high heat conductivity. For example, the heat dissipation sheet 420 may be a graphite sheet described above, but is not limited thereto.

According to an embodiment, the cushion 430 may be disposed on a second portion 412 of the first encapsulation film 410. The cushion 430 being disposed on the second portion 412 of the first encapsulation film 410 may be referred to as the cushion 430 being disposed on another partial area (e.g., the second portion 412) of the first encapsulation film 410 different from the partial area (e.g., the first portion 411) the first encapsulation film 410 in which the heat dissipation sheet 420 is disposed.

According to an embodiment, the cushion 430 may be configured to absorb an impact of the display 230 by being disposed under the display 230. The cushion 430 may be formed from a material such as an sponge having elasticity to alleviate the impact applied to the display 230. When an impact is applied to the display 230, the impact may be transmitted from the display 230 to the cushion 430, and the cushion 430 may be deformed by absorbing the impact. By deforming the cushion 430, the impact is absorbed, and damage to the display 230 may be reduced. The cushion 430 may be restored to an original shape again, by having elasticity.

According to an embodiment, the cushion 430 may be spaced apart from the heat dissipation sheet 420. In case that the heat dissipation sheet 420 and the cushion 430 are not spaced apart from each other and contact each other, an impact absorption effect by the cushion 430 and a heat dissipation effect by the heat dissipation sheet 420 may be reduced, and it may be difficult to form the encapsulation structure 400 surrounded by encapsulation films. As the cushion 430 is spaced apart from the heat dissipation sheet 420, a gap may be formed between the heat dissipation sheet 420 and the cushion 430.

According to an embodiment, the second encapsulation film 440 may cover the heat dissipation sheet 420. The second encapsulation film 440 may be referred to as an upper film. For example, the heat dissipation sheet 420 may be fully covered by the second encapsulation film 440. When the second encapsulation film 440 is attached to the first encapsulation film 410, the heat dissipation sheet 420 may be surrounded by the first encapsulation film 410 and the second encapsulation film 440. The heat dissipation sheet 420 being surrounded by the first encapsulation film 410 and the second encapsulation film 440 may be referred to as the heat dissipation sheet 420 not being exposed to the outside of the first encapsulation film 410 and the second encapsulation film 440, as the heat dissipation sheet 420 is disposed between the first encapsulation film 410 and the second encapsulation film 440.

As described above, since a graphite forming the heat dissipation sheet 420 may be easily broken, dust of the graphite due to an impact may be caused. When the dust diffuses into the electronic device 101, the dust may flow into electronic components and cause damage or malfunction of the electronic components. According to an embodiment, the heat dissipation sheet 420 may be surrounded by the first encapsulation film 410 and the second encapsulation film 440 by being disposed on the first encapsulation film 410 and being covered by the second encapsulation film 440. Even when the graphite forming the heat dissipation sheet 420 is broken, the graphite dust may not leak out to the outside of the encapsulation structure 400 in a space surrounded by the first encapsulation film 410 and the second encapsulation film 440. The first encapsulation film 410 and the second encapsulation film 440 may be formed from a polymer. For example, the first encapsulation film 410 and the second encapsulation film 440 may be formed from polyethylene terephthalate (PET), but are not limited thereto.

According to an embodiment, the second encapsulation film 440 may partially cover the cushion 430. The second encapsulation film 440 partially covering the cushion 430 may be referred to as a portion of the cushion 430 being exposed between the first encapsulation film 410 and the second encapsulation film 440. For example, a lateral surface 431 of the cushion 430 may be aligned with a boundary between the first encapsulation film 410 and the second encapsulation film 440. Since the lateral surface 431 of the cushion 430 is aligned with the boundary between the first encapsulation film 410 and the second encapsulation film 440, the second portion 412 of the first encapsulation film 410 in which the cushion 430 is disposed for attachment to the second encapsulation film 440 may not protrude from the cushion 430. If the first encapsulation film 410 and the second encapsulation film 440 fully cover the cushion 430, the first encapsulation film 410 may protrude to an outside of the lateral surface 431 of the cushion 430, and the second encapsulation film 440 may be attached to the protruding portion of the first encapsulation film 410. In this case, a boundary of the encapsulation structure 400 in which the cushion 430 is not disposed is extended, and an area in which the display 230 may not be protected by the cushion 430 may be increased. According to an embodiment, since the second encapsulation film 440 partially covers the cushion 430 and the portion of the cushion 430 is exposed between the first encapsulation film 410 and the second encapsulation film 440, an area in which the display 230 may not be protected by the cushion 430 may be reduced.

According to an embodiment, the encapsulation structure 400 may be disposed on the first support 215. For example, the first support 215 may include a first surface 215a facing the display 230 and a second surface 215b opposite the first surface 215a. The first surface 215a may face a +z direction, and the second surface 215b may face the -z direction. For example, the encapsulation structure 400 may be disposed on the first surface 215a of the first support 215 facing the display 230.

According to an embodiment, the cushion 430 may be disposed to adjacent a first hinge plate 252. For example, a distance between the first hinge plate 252 and the cushion 430 may be closer than a distance between the first hinge plate 252 and the heat dissipation sheet 420. As the cushion 430 is disposed to adjacent the first hinge plate 252, a distance (e.g., a first distance D1) between a periphery of the first support 215 facing the first hinge plate 252 and the encapsulation structure 400 may be relatively reduced.

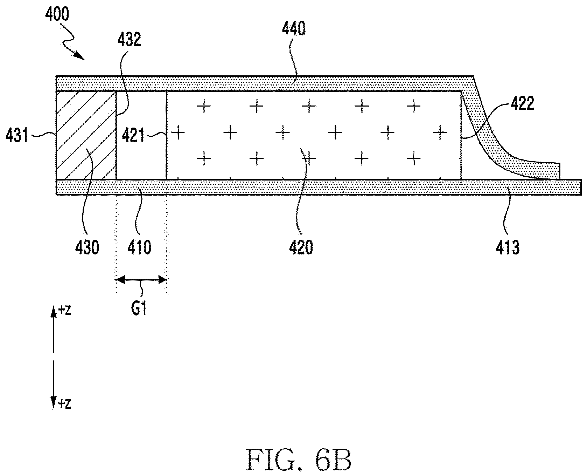

As described above, the heat dissipation sheet 420 may be surrounded by the first encapsulation film 410 and the second encapsulation film 440. In order to prevent the material (e.g., graphite) forming the heat dissipation sheet 420 from leaking out to the outside of the encapsulation structure 400, the heat dissipation sheet 420 may not be exposed to the outside of the encapsulation structure 400, by being disposed between the first encapsulation film 410 and the second encapsulation film 440. In order to prevent the heat dissipation sheet 420 from being exposed to the outside of the encapsulation structure 400, the first encapsulation film 410 and the second encapsulation film 440 may be attached to each other in an outer side of the heat dissipation sheet 420. For example, the first encapsulation film 410 disposed on the first support 215 may include a third portion 413 (e.g., a third portion 413 of FIG. 6B) protruding from the first portion 411 in which the heat dissipation sheet 420 is disposed, and the second encapsulation film 440 may be attached to the protruding third portion 413. Since the third portion 413 to which the first encapsulation film 410 and the second encapsulation film 440 are attached is positioned in the outer side of the heat dissipation sheet 420, a distance (e.g., a second distance) between the periphery of the first support 215 facing the first hinge plate 252 and the encapsulation structure 400 may be relatively increased. For example, in case that the encapsulation structure 400 does not include the cushion 430, the distance (e.g., the second distance) between the periphery of the first support 215 facing the first hinge plate 252 and the encapsulation structure 400 may be approximately 0.8 mm or more.

According to an embodiment, since the cushion 430 is not fully covered by the second encapsulation film 440, the lateral surface 431 of the cushion 430 may be exposed between the first encapsulation film 410 and the second encapsulation film 440. Since the material forming the cushion 430 does not generate dust, unlike the heat dissipation sheet 420, it may not be fully surrounded by the first encapsulation film 410 and the second encapsulation film 440. At a periphery of the encapsulation structure 400 in which the cushion 430 is disposed, the first encapsulation film 410 and the second encapsulation film 440 may not be attached to each other. As the first encapsulation film 410 and the second encapsulation film 440 are not attached to each other at the periphery of the encapsulation structure 400 in which the cushion 430 is disposed, a portion in which the first encapsulation film 410 and the second encapsulation film 440 protrude from the cushion 430 may not be necessary.

According to an embodiment, since the first encapsulation film 410 and the second encapsulation film 440 are not attached at the periphery of the encapsulation structure 400 in which the cushion 430 is disposed, the distance (e.g., the first distance D1) between the periphery of the first support 215 facing the first hinge plate 252 and the encapsulation structure 400 may be relatively reduced. For example, in FIG. 4, the distance (e.g., the first distance D1) between the periphery of the first support 215 facing the first hinge plate 252 and the encapsulation structure 400 may be approximately 0.3 mm or less.

According to an embodiment, since the first distance D1 is shorter than the second distance, extent in which the heat dissipation sheet 420 may be disposed and extent in which the cushion 430 may be disposed may be increased. For example, the encapsulation structure 400 according to an embodiment may have the heat dissipation sheet 420 and the cushion 430 having relatively large extent. The encapsulation structure 400 according to an embodiment may reduce damage to the display 230 by absorbing an impact on relatively wider extent through the cushion 430 having the relatively large extent. The encapsulation structure 400 according to an embodiment may be configured to effectively dissipate heat caused by electronic components through the heat dissdipation sheet 420 having the relatively large extent. According to an embodiment, as the cushion 430 is disposed to adjacent the first hinge plate 252, the impact absorption effect and the heat dissipation effect may be improved.

According to an embodiment, as the heat dissipation sheet 420 and the cushion 430 are disposed between the first encapsulation film 410 and the second encapsulation film 440, a gap (e.g., a first gap G1) between the heat dissipation sheet 420 and the cushion 430 may be relatively reduced. For example, in case that the cushion 430 is not disposed between the first encapsulation film 410 and the second encapsulation film 440, and is disposed outside the encapsulation structure 400, a gap (e.g., a second gap) between the heat dissipation sheet 420 and the encapsulation film may be relatively increased.

In case that the cushion 430 is disposed outside the encapsulation structure 400, the gap (e.g., the second gap) between the cushion 430 and the heat dissipation sheet 420 may be relatively increased. As described above, the first encapsulation film 410 and the second encapsulation film 440 may be attached to each other in the outer side of the heat dissipation sheet 420 so that the heat dissipation sheet 420 is not exposed to the outside of the encapsulation structure 400. For example, the first encapsulation film 410 disposed on the first support 215 may include the portion (e.g., the third portion 413) protruding from the first portion 411 in which the heat dissipation sheet 420 is disposed, and the second encapsulation film 440 may be attached to the protruding portion. Since the portion to which the first encapsulation film 410 and the second encapsulation film 440 are attached is positioned in the outer side of the heat dissipation sheet 420, the gap (e.g., the second gap) between the heat dissipation sheet 420 disposed inside the encapsulation structure 400 and the cushion 430 disposed outside the encapsulation structure 400 may be relatively increased. For example, in case that the cushion 430 is disposed outside the encapsulation structure 400, the gap (e.g., the second gap) between the heat dissipation sheet 420 and the cushion 430 may be approximately 1.5 mm.

The encapsulation structure 400 according to an embodiment may include the cushion 430. As described above, the cushion 430 may be disposed on the second portion 412 of the first encapsulation film 410, and may be partially covered by the second encapsulation film 440. As the cushion 430 is included in the encapsulation structure 400, the gap (e.g., the first gap G1) between the heat dissipation sheet 420 and the cushion 430 may be reduced. Since the portion to which the first encapsulation film 410 and the second encapsulation film 440 are attached is not positioned between the heat dissipation sheet 420 and the encapsulation structure 400 in case that the cushion 430 is disposed between the first encapsulation film 410 and the second encapsulation film 440, the gap (e.g., the first gap G1) between the heat dissipation sheet 420 and the cushion 430 may be relatively small. For example, the gap (e.g., the first gap G1) between the heat dissipation sheet 420 and the cushion 430 may be approximately 1.0 mm or less (e.g., approximately 0.5 mm).

According to an embodiment, since the first gap G1 is shorter than the second gap, the extent in which the heat dissipation sheet 420 may be disposed and the extent in which the cushion 430 may be disposed may be increased. For example, the encapsulation structure 400 according to an embodiment illustrated in FIG. 4 may have the heat dissipation sheet 420 and the cushion 430 having the relatively large extent. The encapsulation structure 400 according to an embodiment may reduce damage to the display 230 by absorbing the impact on the relatively wider extent through the cushion 430 having the relatively large extent. The encapsulation structure 400 according to an embodiment may be configured to effectively dissipate the heat caused by the electronic components through the heat dissipation sheet 420 having the relatively large extent. According to an embodiment, as the cushion 430 is disposed in the encapsulation structure 400, the impact absorption effect and the heat dissipation effect may be improved.

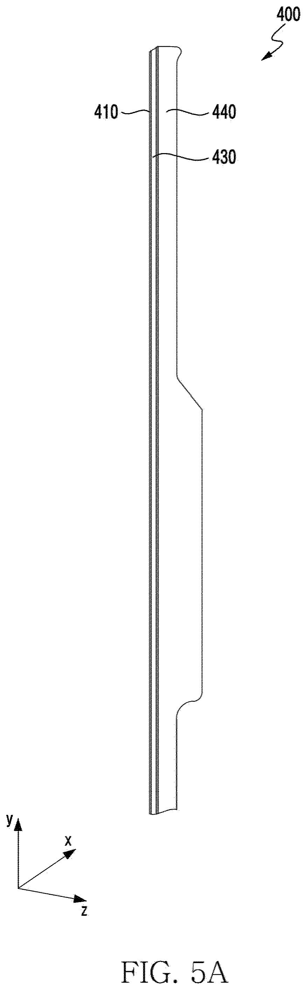

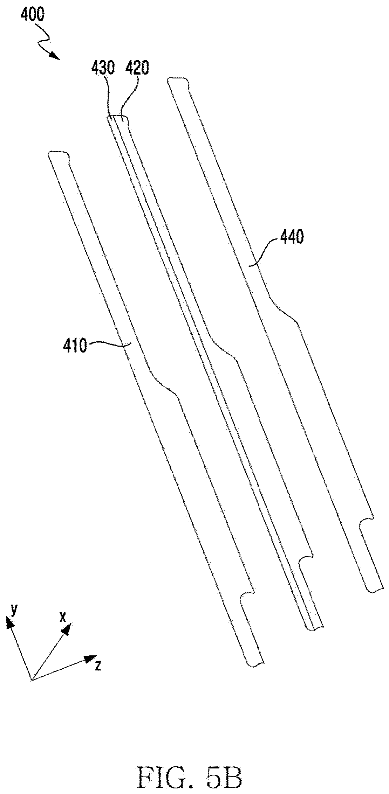

FIG. 5A illustrates an encapsulation structure according to an embodiment. FIG. 5B is an exploded perspective view of an encapsulation structure according to an embodiment.

Referring to FIGS. 5A and 5B, an encapsulation structure 400 may have an exterior formed by a first encapsulation film 410, a second encapsulation film 440, and a cushion 430. A heat dissipation sheet 420 and the cushion 430 may be disposed between the first encapsulation film 410 and the second encapsulation film 440. Since the heat dissipation sheet 420 is surrounded by the first encapsulation film 410 and the second encapsulation film 440, it may not be exposed to the outside of the encapsulation structure 400. Due to an impact, a heat dissipation material (e.g., graphite) forming the heat dissipation sheet 420 may be broken, and dust of the heat dissipation material may be generated. Since the heat dissipation sheet 420 is surrounded by the first encapsulation film 410 and the second encapsulation film 440, even when the dust of the heat dissipation material is generated, it may not leak out to the outside of the encapsulation structure 400 and may remain inside the encapsulation structure 400. According to an embodiment, as the dust of the heat dissipation material does not leak out to the outside of a heat dissipation structure, damage and malfunction of electronic components caused by the dust of the heat dissipation material may be reduced.

According to an embodiment, the cushion 430 may have elasticity. When an impact is applied to a display (e.g., the display 230 of FIG. 4), the impact may be transmitted to the cushion 430 positioned under the display 230. Deformation of a shape of the cushion 430 may be caused by absorbing the impact by the cushion 430 having the elasticity. Since the cushion 430 may absorb the impact under the display 230, damage to the display 230 due to an impact between the display 230 having flexibility and a rigid foldable housing (e.g., the foldable housing 201 of FIG. 2A) (e.g., a first support (e.g., the first support 215 of FIG. 4)) may be reduced.

According to an embodiment, the encapsulation structure 400 may have a length with respect to a direction (e.g., a y-axis direction). For example, the encapsulation structure 400 may be disposed adjacent to a first hinge plate 252 on the first support 215, and the encapsulation structure 400 may extend in the direction to correspond to an extension direction of the first hinge plate 252. The encapsulation structure 400 may be configured to absorb an impact on a bending portion (e.g., the bending portion 233 of FIG. 2A) of the display 230 by being disposed adjacent to a periphery of the first support 215 facing the first hinge plate 252. Since the bending portion 233 of the display 230 is configured to be bent based on a rotation of a first housing part (e.g., the first housing part 210 of FIG. 3A) and a second housing part (e.g., the second housing part 220 of FIG. 3A), it may be more vulnerable to an impact than a first planar portion 231 and a second planar portion 232. Since the encapsulation structure 400 disposed adjacent to the first hinge plate 252 may be disposed close to the bending portion 233 of the display 230, damage to the bending portion 233 of the display 230 may be reduced by absorbing the impact on the bending portion 233.

According to an embodiment, the heat dissipation sheet 420 may be surrounded by the first encapsulation film 410, the second encapsulation film 440, and the cushion 430. The heat dissipation sheet 420 may not be exposed to the outside of the encapsulation structure 400 by being surrounded by the first encapsulation film 410, the second encapsulation film 440, and the cushion 430. Since the heat dissipation sheet 420 is surrounded by the first encapsulation film 410, the second encapsulation film 440, and the cushion 430, even when the dust of the heat dissipation material (e.g., graphite sheet) forming the heat dissipation sheet 420 is generated by the impact, the dust of the heat dissipation material may not leak out to the outside of the encapsulation structure 400. According to an embodiment, damage to electronic components due to the dust of the heat dissipation material may be reduced.

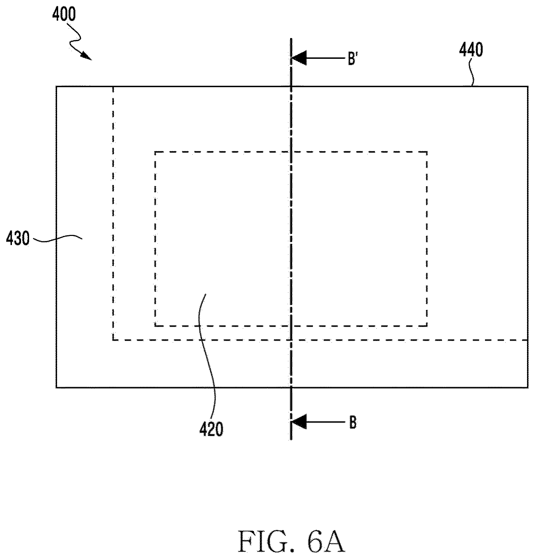

FIG. 6A is a plan view of an encapsulation structure according to an embodiment. FIG. 6B is a cross-sectional view of the encapsulation structure of FIG. 6A cut along line B-B'.

Referring to FIG. 6A, a cushion 430 may be disposed to surround a portion of a heat dissipation sheet 420. As described above, the cushion 430 may be spaced apart from the heat dissipation sheet 420. The cushion 430 may be spaced apart from a periphery of the heat dissipation sheet 420 and may partially surround the heat dissipation sheet 420.

According to an embodiment, the heat dissipation sheet 420 may have an approximately rectangular shape. Since a first encapsulation film (e.g., the first encapsulation film 410 of FIG. 4) and a second encapsulation film (e.g., the second encapsulation film 440 of FIG. 4) surround the heat dissipation sheet 420 so that a heat dissipation material (e.g., graphite) forming the heat dissipation sheet 420 does not leak out to the outside of an encapsulation structure 400, the heat dissipation sheet 420 may be spaced apart from peripheries of the first encapsulation film 410 and the second encapsulation film 440. Since a lateral surface of the cushion 430 is exposed through a periphery of the encapsulation structure 400, a periphery of the cushion 430 may be contacted with the peripheries of the first encapsulation film 410 and the second encapsulation film 440. The cushion 430 may be disposed to be adjacent to two sides of the heat dissipation sheet 420 having a substantially rectangular shape. As illustrated in FIG. 6A, the cushion 430 may have an approximately L shape, but is not limited thereto.

Referring to FIG. 6B, the heat dissipation sheet 420 and the cushion 430 may be disposed between the first encapsulation film 410 and the second encapsulation film 440. Since the cushion 430 is disposed to surround a portion of the heat dissipation sheet 420, the cushion 430 may face a portion of the periphery of the heat dissipation sheet 420. For example, a lateral surface 421 of the heat dissipation sheet 420 may face the cushion 430, and another lateral surface 422 of the heat dissipation sheet 420 opposite to the lateral surface 421 may not face the cushion 430.

According to an embodiment, the first encapsulation film 410 and the second encapsulation film 440 may be attached to each other at a portion protruding from the other lateral surface 422 of the heat dissipation sheet 420 that does not face the cushion 430. For example, the first encapsulation film 410 may include a third portion 413 protruding from the other lateral surface of the heat dissipation sheet 420, and the second encapsulation film 440 may be attached on the third portion 413 of the first encapsulation film 410 protruding from the other lateral surface of the heat dissipation sheet 420. As the first encapsulation film 410 and the second encapsulation film 440 are attached, the heat dissipation sheet 420 may be surrounded by the first encapsulation film 410 and the second encapsulation film 440.

According to an embodiment, the lateral surface of the cushion 430 may be exposed between the first encapsulation film 410 and the second encapsulation film 440. A lateral surface 431 of the cushion 430 may be aligned with a boundary between the first encapsulation film 410 and the second encapsulation film 440. Another lateral surface 432 of the cushion 430 opposite to the lateral surface 431 of the cushion 430 exposed between the first encapsulation film 410 and the second encapsulation film 440 may face the lateral surface 421 of the heat dissipation sheet 420. A gap between the lateral surface 421 of the heat dissipation sheet 420 and the other lateral surface 432 of the cushion 430 may correspond to a gap (e.g., the first gap G1 of FIG. 4) between the heat dissipation sheet 420 and the cushion 430. For example, the gap may be approximately 1.0 mm or less (e.g., approximately 0.5 mm), but is not limited thereto.

According to an embodiment, as the cushion 430 is disposed to surround the portion of the heat dissipation sheet 420, a portion in which the first encapsulation film 410 and the second encapsulation film 440 are attached to each other may be formed. In an embodiment illustrated in FIGS. 6A and 6B, the heat dissipation sheet 420 may be surrounded by the first encapsulation film 410, the second encapsulation film 440, and the cushion 430. As the heat dissipation sheet 420 is surrounded by the first encapsulation film 410, the second encapsulation film 440, and the cushion 430, the heat dissipation material (e.g., graphite) forming the heat dissipation sheet 420 may not leak out to the outside of the encapsulation structure 400. Since the heat dissipation sheet 420 is surrounded by the first encapsulation film 410, the second encapsulation film 440, and the cushion 430, even when the heat dissipation sheet 420 is broken by an impact and dust of the heat dissipation material is generated, the dust of the heat dissipation material may not leak out to the outside of the encapsulation structure 400 and may remain inside the encapsulation structure 400.

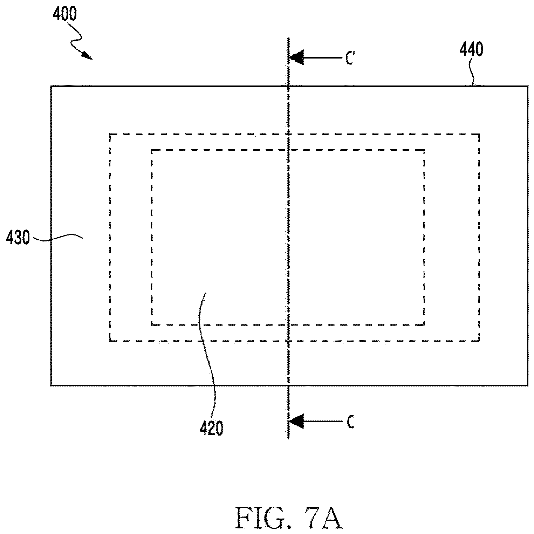

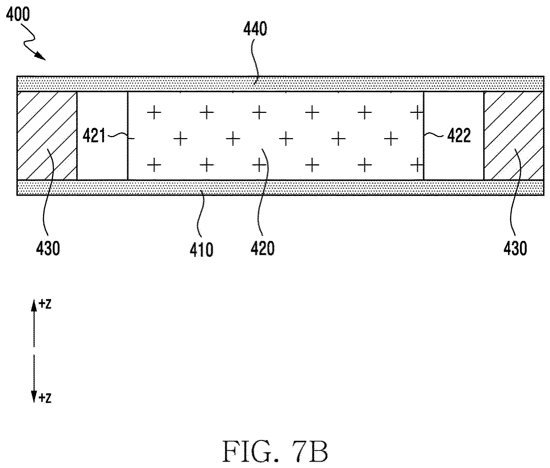

FIG. 7A is a plan view of an encapsulation structure according to an embodiment. FIG. 7B is a cross-sectional view of the encapsulation structure of FIG. 7A, cut along line C-C'.

Referring to FIG. 7A, a cushion 430 may be disposed to entirely surround a heat dissipation sheet 420. The cushion 430 may be spaced apart from a periphery of the heat dissipation sheet 420 and may entirely surround the periphery of the heat dissipation sheet 420.

According to an embodiment, the heat dissipation sheet 420 may have an approximately rectangular shape. The heat dissipation sheet 420 may not be exposed to the outside of an encapsulation structure 400 so that a heat dissipation material (e.g., graphite) forming the heat dissipation sheet 420 does not leak out to the outside of the encapsulation structure 400. Since a lateral surface 431 of the cushion 430 is exposed through a periphery of the encapsulation structure 400, a periphery of the cushion 430 may be entirely contacted with peripheries of a first encapsulation film 410 and a second encapsulation film 440. The cushion 430 may be disposed to be adjacent to four sides of the heat dissipation sheet 420 having an approximately rectangular shape. As illustrated in FIG. 7A, the cushion 430 may have an approximately quadrangular ring shape, but is not limited thereto.

Referring to FIG. 7B, the heat dissipation sheet 420 and the cushion 430 may be disposed between the first encapsulation film 410 and the second encapsulation film 440. Since the cushion 430 is disposed to entirely surround the heat dissipation sheet 420, the cushion 430 may face the periphery of the heat dissipation sheet 420. For example, a lateral surface 421 of the heat dissipation sheet 420 may face the cushion 430, and another lateral surface 422 of the heat dissipation sheet 420 opposite to the lateral surface may also face the cushion 430.

According to an embodiment, the first encapsulation film 410 and the second encapsulation film 440 may not be attached to each other. For example, the first encapsulation film 410 may be disposed under (e.g., a -z direction) the heat dissipation sheet 420 and the cushion 430. The first encapsulation film 410 may be contacted with a lower surface of the heat dissipation sheet 420 and a lower surface of the cushion 430. The second encapsulation film 440 may be disposed over (e.g., a +z direction) the heat dissipation sheet 420 and the cushion 430. The second encapsulation film 440 may be contacted with an upper surface of the heat dissipation sheet 420 and the lower surface of the cushion 430. Since the cushion 430 entirely surrounds the heat dissipation sheet 420, even when the first encapsulation film 410 and the second encapsulation film 440 are not attached to each other, the heat dissipation sheet 420 may be disposed in the encapsulation structure 400. For example, an outer surface of the heat dissipation sheet 420 may face an inner surface of the cushion 430.

According to an embodiment, as the cushion 430 is disposed to entirely surround the heat dissipation sheet 420, the heat dissipation sheet 420 may be surrounded by the first encapsulation film 410, the second encapsulation film 440, and the cushion 430. As the heat dissipation sheet 420 is surrounded by the first encapsulation film 410, the second encapsulation film 440, and the cushion 430, the heat dissipation material (e.g., graphite) forming the heat dissipation sheet 420 may not leak out to the outside of the encapsulation structure 400. Since the heat dissipation sheet 420 is surrounded by the first encapsulation film 410, the second encapsulation film 440, and the cushion 430, even when the heat dissipation sheet 420 is broken by an impact and dust of the heat dissipation material is generated, the dust of the heat dissipation material may not leak out to the outside of the encapsulation structure 400 and may remain inside the encapsulation structure 400.

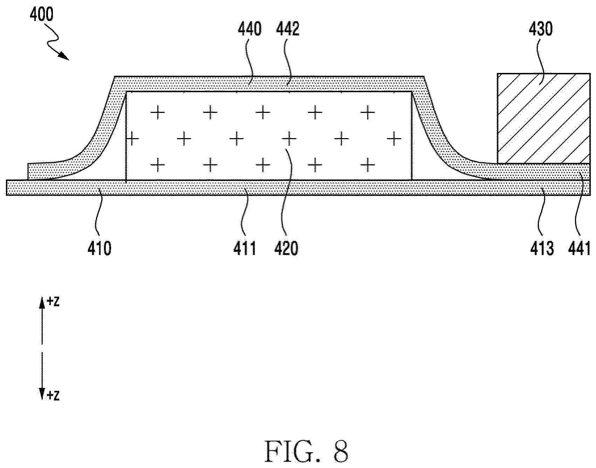

FIG. 8 illustrates an example of an encapsulation structure in which a cushion is disposed on a second encapsulation film.

Referring to FIG. 8, a cushion 430 may be disposed outside a first encapsulation film 410 and a second encapsulation film 440. For example, a heat dissipation sheet 420 may be surrounded by the first encapsulation film 410 and the second encapsulation film 440. The first encapsulation film 410 may be disposed under (e.g., a -z direction) the heat dissipation sheet 420, and the second encapsulation film 440 may be disposed over (e.g., a +z direction) the heat dissipation sheet 420. The first encapsulation film 410 and the second encapsulation film 440 may protrude from the heat dissipation sheet 420 and may be attached to each other.

For example, the first encapsulation film 410 may include a third portion 413 extending from a first portion 411 in which the heat dissipation sheet 420 is disposed, and spaced apart from the heat dissipation sheet 420. The third portion 413 may not be contacted with the heat dissipation sheet 420. The second encapsulation film 440 may be attached to the third portion 413 of the first encapsulation film 410 by extending from a portion contacted with the heat dissipation sheet 420. As the first encapsulation film 410 and the second encapsulation film 440 are attached to each other, the heat dissipation sheet 420 between the first encapsulation film 410 and the second encapsulation film 440 may be disposed inside an encapsulation structure 400.

For example, the cushion 430 may be disposed on the second encapsulation film 440. The cushion 430 may be disposed on a portion 441 of the second encapsulation film 440 attached on the third portion 413 of the first encapsulation film 410. Since a distance between a display (e.g., the display 230 of FIG. 2A) and a support (e.g., the first support 215 or the second support 227 of FIG. 2C) increases, in case that the cushion 430 is disposed on a portion 442 contacted with the heat dissipation sheet 420 of the second encapsulation film 440, a thickness of an electronic device 101 may be increased. The cushion 430 may be disposed on the portion 441 of the second encapsulation film 440 that does not overlap the heat dissipation sheet 420 in order to reduce an increase in the thickness of the electronic device 101. In case that the cushion 430 is not disposed on the second encapsulation film 440 and is disposed outside the encapsulation structure 400, a gap between the heat dissipation sheet 420 and the encapsulation structure 400 may increase. As extent of the heat dissipation sheet 420 and extent of the cushion 430 are reduced, in case that the gap is increased, an impact absorption effect by the cushion 430 and a heat dissipation effect by the heat dissipation sheet 420 may be reduced. The cushion 430 may be disposed on the second encapsulation film 440 for the impact absorption effect and the heat dissipation effect. In case that the cushion 430 is disposed on the second encapsulation film 440, the gap between the heat dissipation sheet 420 and the cushion 430 may be smaller than in case that the cushion 430 is disposed outside the encapsulation structure 400.

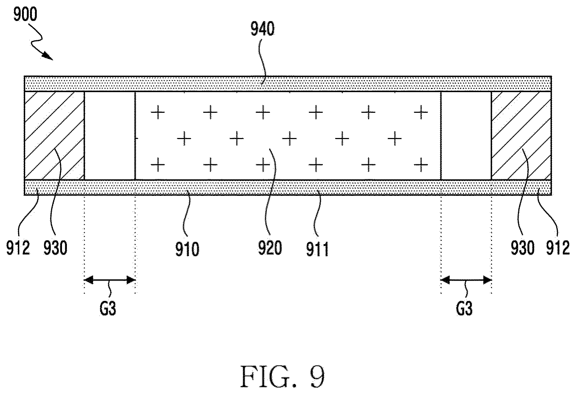

FIG. 9 illustrates an encapsulation structure according to an embodiment including a shield sheet.

The above-described encapsulation structure (e.g., the encapsulation structure 400 of FIG. 4) has been described as including a heat dissipation sheet (e.g., the heat dissipation sheet 420 of FIG. 4), but the heat dissipation sheet 420 may be replaced with a shield sheet 920 of FIG. 9.

Referring to FIG. 9, an electronic device 101 according to an embodiment may include another encapsulation structure 900. The other encapsulation structure 900 may have substantially the same structure as the encapsulation structure 400 described above. For example, the other encapsulation structure 900 may be substantially the same as the above-described encapsulation structure 400, except that the heat dissipation sheet 420 is replaced with the shield sheet 920 in the encapsulation structure 400.

According to an embodiment, the other encapsulation structure 900 may include a third encapsulation film 910, the shield sheet 920, another cushion 930, and a fourth encapsulation film 940.

According to an embodiment, the third encapsulation film 910 may be disposed on a foldable housing (e.g., the foldable housing 201 of FIG. 3A). For example, the third encapsulation film 910 may be disposed on a first support (e.g., the first support 215 of FIG. 3A) of a first housing part (e.g., the first housing part 210 of FIG. 3A) or a second support (e.g., the second support 227 of FIG. 3A) of a second housing part (e.g., the second housing part 220 of FIG. 3A).

According to an embodiment, the shield sheet 920 may be disposed on a first portion 911 of the third encapsulation film 910. The shield sheet 920 may be configured to shield a magnetic field emitted from electronic components of the electronic device 101. The shield sheet 920 may be configured to reduce interference between the electronic components and reduce noise and malfunction of the electronic components by shielding the magnetic field. For example, the shield sheet 920 may include magnetic metal powder (MMP). For example, the magnetic metal powder may include at least one selected from iron, aluminum, nickel, silicon, or a combination thereof. For example, the shield sheet 920 may include a ferromagnetic material (e.g., steel plate cold commercial (SPCC)) or an aspirated radiation shield (ARS), but is not limited thereto.

According to an embodiment, the other cushion 930 may be disposed on a second portion 912 of the third encapsulation film 910. The other cushion 930 may be spaced apart from the shield sheet 920. The other cushion 930 included in the other encapsulation structure 900 may be substantially the same as the above-described cushion (e.g., the cushion 430 of FIG. 4).

According to an embodiment, the fourth encapsulation film 940 may cover the shield sheet 920 and partially cover the other cushion 930. For example, the shield sheet 920 may not be exposed to the outside of the third encapsulation film 910 and the fourth encapsulation film 940 by being disposed between the third encapsulation film 910 and the fourth encapsulation film 940. The other cushion 930 may be exposed between the third encapsulation film 910 and the fourth encapsulation film 940. For example, the other cushion 930 may be disposed to entirely surround the shield sheet 920. A lower surface of the shield sheet 920 may be contacted with the third encapsulation film 910, an upper surface of the shield sheet 920 may be contacted with the fourth encapsulation film 940, and a lateral surface of the shield sheet 920 may be surrounded by the other cushion 930. A shield material (e.g., the MMP) forming the shield sheet 920 may not leak out to the outside of the other encapsulation structure 900 by being surrounded by the third encapsulation film 910, the fourth encapsulation film 940, and the other cushion 930. As illustrated in FIG. 9, the other cushion 930 may be disposed to entirely surround the shield sheet 920, but is limited thereto. For example, the other cushion 930 may surround a portion of the shield sheet 920, and the third encapsulation film 910 and the fourth encapsulation film 940 may protrude to the outer side of the shield sheet 920 and be attached to each other.

According to an embodiment, as the other encapsulation structure 900 includes the shield sheet 920 and the other cushion 930, a gap (e.g., a third gap G3) between the shield sheet 920 and the other cushion 930 may be reduced. As the third gap G3 is reduced, extent of the shield sheet 920 and extent of the other cushion 930 may increase. A magnetic field shield effect of the shield sheet 920 and an impact absorption effect of the other cushion 930 may be improved by increasing the extend of the shield sheet 920 and the extend of the other cushion 930.

Referring back to FIG. 3A, the electronic device 101 according to an embodiment may include magnets 951 and 952 for fixing the first housing part 210 and the second housing part 220 in a folded state in which the first housing part 210 and the second housing part 220 overlap. For example, the first magnet 951 may be disposed in the first housing part 210, and the second magnet 952 may be disposed in the second housing part 220. The second magnet 952 may be paired with the first magnet 951. As the first housing part 210 and the second housing part 220 are rotated, the first magnet 951 and the second magnet 952 may be close to each other, and an attractive force between the first magnet 951 and the second magnet 952 may act. The attractive force may be configured to maintain the electronic device 101 in the folded state by fixing the first housing part 210 and the second housing part 220. A user may change the electronic device 101 from the folded state to an unfolded state by applying an external force greater than the attractive force to the electronic device 101 in the folded state.

Since the magnets 951 and 952 form a magnetic field, in case that the magnetic field interacts electronically with electronic components of the electronic device 101 disposed around the magnets 951 and 952, noise may be caused to the electronic components or malfunction of the electronic components may be caused. According to an embodiment, the other encapsulation structure 900 including the shield sheet 920 may be configured to reduce an influence of the magnetic field formed from the magnets 951 and 952 on the electronic components, by being disposed around the magnets 951 and 952. The other encapsulation structure 900 may be configured to absorb an impact applied to a display (e.g., the display 230 of FIG. 2A) and reduce damage to the display 230 by including the other cushion 930. In addition, the other encapsulation structure 900 may be disposed around a component forming the magnetic field.

An electronic device 101 is provided. The electronic device 101 may comprise a housing 201. The electronic device 101 may comprise a display 230. The electronic device 101 may comprise a first encapsulation film 410 disposed on the housing 201. The electronic device 101 may comprise a heat dissipation sheet 420, positioned under the display 230, disposed on a first portion 411 of the first encapsulation film 410. The electronic device 101 may comprise a cushion 430, positioned under the display 230, disposed on a second portion 412 of the first encapsulation film 410 and spaced apart from the heat dissipation sheet 420. The electronic device 101 may comprise a second encapsulation film 440 covering the heat dissipation sheet 420 and partially covering the cushion 430.

According to an embodiment, a gap (e.g., the first gap G1 of FIG. 4) between the heat dissipation sheet 420 and the cushion 430 may be 1 mm or less.

According to an embodiment, the cushion 430 may be disposed to totally surround the heat dissipation sheet 420.

According to an embodiment, the cushion 430 may be disposed to partially surround the heat dissipation sheet 420. The second encapsulation film 440 may include a portion connected to the first encapsulation film 410.

According to an embodiment, the portion of the second encapsulation film 440 connected to the first encapsulation film 410 may be attached to a third portion 413 of the first encapsulation film 410 different from the first portion 411 of the first encapsulation film 410 on which the heat dissipation sheet 420 is disposed and the second portion 412 of the first encapsulation film 410 on which the cushion 430 is disposed.

According to an embodiment, a portion of the cushion 430 may be exposed between the first encapsulation film 410 and the second encapsulation film 440.

According to an embodiment, the housing 201 may be a foldable housing 201 including a first housing part 210 and a second housing part 220 rotatably coupled to the first housing part 210. The display 230 may be a flexible display 230.

According to an embodiment, the first housing part 210 may include a support 215 comprising a first surface 215a facing the flexible display 230 and a second surface 215b, opposite to the first surface 215a, contacted with an electronic component. The first encapsulation film 410 may be disposed on the first surface 215a of the support 215.

According to an embodiment, the electronic component may include an application processor (AP) 120 or power management circuitry 340. The heat dissipation sheet 420 may be configured to dissipate heat caused from the AP 120 or the power management circuitry 340.

According to an embodiment, the electronic device 101 may further comprise a hinge assembly 250 including hinge plates rotatably connecting the first housing part 210 and the second housing part 220. The hinge plates may include a first hinge plate 252 coupled to the first housing part 210 and a second hinge plate 253 coupled to the second housing part 220. The cushion 430 may be disposed adjacent to the first hinge plate 252.

According to an embodiment, a distance between a periphery of the support 215 facing the first hinge plate 252 and the cushion 430 may be 0.3 mm or less.

According to an embodiment, the flexible display 230 may include a first planar portion 231 supported by the first housing part 210, a second planar portion 232 supported by the second housing part 220, and a bending portion 233, between the first planar portion 231 and the second planar portion 232, configured to be bent based on a rotation of the first housing part 210 and the second housing part 220.

According to an embodiment, the heat dissipation sheet 420 may be surrounded by the first encapsulation film 410, the cushion 430, and the second encapsulation film 440.

According to an embodiment, the electronic device 101 may further comprise a third encapsulation film 910 disposed on the housing 201. The electronic device 101 may further comprise a shield sheet 920, disposed on a first portion 411 of the third encapsulation film 910, to shield a magnetic field. The electronic device 101 may further comprise another cushion 930, disposed on a second portion 412 of the third encapsulation film 910 and spaced apart from the shield sheet 920. The electronic device 101 may further comprise a fourth encapsulation film 940 covering the shield sheet 920 and partially covering the another cushion 930.

According to an embodiment, the electronic device 101 may further comprise a waterproof tape 320 disposed between the housing 201 and the display 230.

An electronic device 101 is provided. The electronic device 101 may comprise a foldable housing 201 including a first housing part 210 and a second housing part 220 rotatably coupled to the first housing part 210. The electronic device 101 may comprise a flexible display 230 disposed over the foldable housing 201. The electronic device 101 may comprise an encapsulation structure 400 disposed between the foldable housing 201 and the flexible display 230. The encapsulation structure 400 may include a first encapsulation film 410 disposed on the foldable housing 201, a heat dissipation sheet 420, positioned under the flexible display 230, disposed on a first portion 411 of the first encapsulation film 410, a cushion 430, positioned under the flexible display 230, disposed on a second portion 412 of the first encapsulation film 410 and spaced apart from the heat dissipation sheet 420, and a second encapsulation film 440 at least partially covering the heat dissipation sheet 420 and the cushion 430.

According to an embodiment, the electronic device 101 may further comprise a hinge assembly 250 including hinge plates rotatably connecting the first housing part 210 and the second housing part 220. The hinge plates may include a first hinge plate 252 coupled to the first housing part 210 and a second hinge plate 253 coupled to the second housing part 220. The first housing part 210 may include a support 215 contacted with an electronic component disposed in the first housing part 210. The encapsulation structure 400 may be disposed on the support 215 to adjacent the first hinge plate 252.

According to an embodiment, a distance between a periphery of the support facing the first hinge plate 252 and the cushion 430 may be 0.3 mm or less.

According to an embodiment, a gap (e.g., the first gap G1 of FIG. 4) between the heat dissipation sheet 420 and the cushion 430 may be 1 mm or less.

According to an embodiment, the cushion 430 may be disposed to at least partially surround the heat dissipation sheet 420.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing;
a display;
a first encapsulation film disposed on the housing;
a heat dissipation sheet, positioned under the display, disposed on a first portion of the first encapsulation film;
a cushion, positioned under the display, disposed on a second portion of the first encapsulation film and spaced apart from the heat dissipation sheet; and
a second encapsulation film covering the heat dissipation sheet and partially covering the cushion.

2. The electronic device of claim 1,
wherein a gap between the heat dissipation sheet and the cushion is 1mm or less.

3. The electronic device of claim 1 or 2,
wherein the cushion is disposed to totally surround the heat dissipation sheet.

4. The electronic device of any one of claims 1 to 3,
wherein the cushion is disposed to partially surround the heat dissipation sheet, and
wherein the second encapsulation film includes a portion attached to the first encapsulation film.

5. The electronic device of claim 4,
wherein the portion of the second encapsulation film attached to the first encapsulation film is attached to a third portion of the first encapsulation film different from the first portion of the first encapsulation film on which the heat dissipation sheet is disposed and the second portion of the first encapsulation film on which the cushion is disposed.

6. The electronic device of any one of claims 1 to 5,
wherein a portion of the cushion is exposed between the first encapsulation film and the second encapsulation film.

7. The electronic device of any one of claims 1 to 6,
wherein the housing is a foldable housing including a first housing part and a second housing part rotatably coupled to the first housing part, and
wherein the display is a flexible display.

8. The electronic device of claim 7,
wherein the first housing part includes a support comprising a first surface facing the flexible display and a second surface, opposite to the first surface, contacted with an electronic component, and
wherein the first encapsulation film is disposed on the first surface of the support.

9. The electronic device of claim 8,
wherein the electronic component includes an application processor (AP) or power management circuitry, and
wherein the heat dissipation sheet is configured to dissipate heat caused from the AP or the power management circuitry.

10. The electronic device of claim 8, further comprising a hinge assembly including hinge plates rotatably connecting the first housing part and the second housing part,
wherein the hinge plates include a first hinge plate coupled to the first housing part and a second hinge plate coupled to the second housing part, and
wherein the cushion is disposed to adjacent the first hinge plate.

11. The electronic device of claim 10,
wherein a distance between a periphery of the support facing the first hinge plate and the cushion is 0.3mm or less.

12. The electronic device of claim 7,
wherein the flexible display includes:
a first planar portion supported by the first housing part,
a second planar portion supported by the second housing part, and
a bending portion, between the first planar portion and the second planar portion, configured to be bent based on a rotation of the first housing part and the second housing part.

13. The electronic device of any one of claims 1 to 12,
wherein the heat dissipation sheet is surrounded by the first encapsulation film, the cushion, and the second encapsulation film.

14. The electronic device of any one of claims 1 to 13, further comprising:
a third encapsulation film disposed on the housing;
a shield sheet, disposed on a first portion of the third encapsulation film, to shield a magnetic field;
another cushion, disposed on a second portion of the third encapsulation film and spaced apart from the shield sheet; and
a fourth encapsulation film covering the shield sheet and partially covering the other cushion.

15. The electronic device of any one of claims 1 to 14, further comprising a waterproof tape disposed between the housing and the display.
